Europäisches Patentamt

European Patent Office

Office européen des brevets

(11) Veröffentlichungsnummer: **0 235 657**
**A1**

(12) **EUROPÄISCHE PATENTANMELDUNG**

(21) Anmeldenummer: **87102156.4**

(51) Int. Cl.⁴: **H 05 K 7/20**

(22) Anmeldetag: **16.02.87**

(30) Priorität: **28.02.86 AT 518/86**

(71) Anmelder: **Siemens Aktiengesellschaft Berlin und München, Wittelsbacherplatz 2, D-8000 München 2 (DE)**

(84) Benannte Vertragsstaaten: **DE FR GB**

(43) Veröffentlichungstag der Anmeldung: **09.09.87 Patentblatt 87/37**

(71) Anmelder: **SIEMENS AKTIENGESELLSCHAFT ÖSTERREICH, Siemensstrasse 88 - 92, A-1210 Wien (AT)**

(84) Benannte Vertragsstaaten: **AT**

(72) Erfinder: **Havranek, Gustav, Speichberggasse 3, A-3002 Purkersdorf (AT)**
Erfinder: **Rumpler, Helmut, Eichbergweg 16, A-3002 Sieding (AT)**

(84) Benannte Vertragsstaaten: **AT DE FR GB**

(54) **Wasserkühleinrichtung für einschiebbare Bauteilgruppen in Geräten der Leistungselektronik.**

(57) Bei einer Wasserkühleinrichtung für einschiebbare Bauteilgruppen in Geräten der Leistungselektronik ist das Trägerelement, auf dem die Bauteile (7) angeordnet sind, als vom Kühlkörper (8) unabhängiger Bauteilträger (2) ausgebildet. Mit jedem der im Verband eines Einschubes (1) in das Gerät eingeschobenen Bauteilträger (2) ist ein wasserdurchflossener, im wesentlichen gerätefest gelagerter Kühlkörper (8) durch die Kraft federnder Elemente (10) an genau aufeinander passenden, an Bauteilträgern (2) und Kühlkörpern (8) ausgebildeten Wärmeübergangsflächen (5, 9) individuell in thermische Wirkverbindung bringbar. Durch eine mechanische Vorrichtung (12-15) können alle Kühlkörper (8) gemeinsam entgegen der Wirkungsrichtung der Kräfte der federnden Elemente (10) von den zugehörigen Bauteilträgern (2) distanziert werden. Ein Austausch von Bauteilträgern (2) ist dadurch ohne Manipulation an Einrichtungen des Kühlwasserkreislaufes ermöglicht.

Vorteilhafte Ausführungsformen der mechanischen Vorrichtung (12-15) werden angegeben.

VPA 86 P 7006

Wasserkühleinrichtung für einschiebbare Bauteilgruppen in Geräten
der Leistungselektronik

Gegenstand der Erfindung ist eine Wasserkühleinrichtung für einschiebbare Bauteilgruppen in Geräten der Leistungselektronik nach dem Prinzip,
bei dem im wesentlichen die Verlustwärme aus den Bauteilen durch eine,
zur Trennung der Bauteile von dem den Kühlkörper durchströmenden Kühlwasser notwendigen, als Trägerelement ausgebildete Schicht gut wärmeleitenden Metalls unmittelbar in das Kühlwasser abfließt.

In allen Geräten, in denen größere Wärmeleistungen abzuführen sind, ist ein
Luft- Wasser- Wärmetauschersystem nahezu unabdingbar. Das Kühlmedium Wasser
verfügt bei einem günstigen Preis über eine relativ konstant niedrige Temperatur und steht im allgemeinen problemlos zur Verfügung. Diese Fakten sowie
der hohe Wärmewert führen zu einem sehr hohen Wirkungsgrad bei geringem
mechanischen Aufwand, wobei das Wärmetauschersystem nahezu wartungsfrei betrieben werden kann.

Wassergekühlte Einheiten in Geräten der Leistungselektronik werden unter
Verwendung handelsüblicher, meist aus Aluminium-Strangpreßprofilen hergestellter Elemente aufgebaut, die vorzugsweise mitttels flexibler Druckschläuche an den Kühlwasserkreislauf angeschlossen sind. Diese weisen mit
Wasser durchströmbare Kanäle oder Kammern sowie eine, vorzugsweise eben gestaltete, insbesondere die elektrischen Bauteile mit hoher Verlustwärme
tragende Außenfläche auf.

Bei großen Geräten, z.B. Computertomographen, Kernspintomographen etc. sind
solche Einheiten in größerer Anzahl, vorzugsweise mit Parallelschaltung der
elektrischen Bauteilegruppen angeordnet. Bei derartigen Geräten ergibt
sich eine besondere Problematik die nachfolgend aufgezeigt werden soll.
Von großer Bedeutung für den Betrieb solcher Anlagen ist die Zuverlässigkeit der Geräte. Meist ist wegen der hohen Anschaffungskosten nur ein Gerät vorhanden. Daher bedeutet ein Ausfall der Anlage eine Unterbrechung bzw. Einstellung der gesamten Diagnostik für geraume Zeit. Da für die meisten Diagnoseabteilungen mit derartigen Geräten Wartelisten existieren, ist eine vollständige Umplanung der vorgesehenen Untersuchungen erforderlich sodaß z.B. ambulante Patienten die nicht untersucht werden können, erneut bestellt werden müssen. Wenn die Anlage ausgefallen ist, muß die Fehlersuche möglichst rasch zum Erfolg führen. Es liegt nahe und ist bekannt, dafür Rechner als Hilfsmittel zu nutzen. Aufgetretene Fehler können automatisch protokolliert werden, sodaß der Servicetechniker die Ursache schnell ermitteln kann. Durch Verwendung gleichartiger, im Störungsfall austauschbarer Baugruppen und gute Zugänglichkeit ist eine Voraussetzung für die rasche Fehlerbeseitigung verwirklicht. Damit könnte die Reparaturdauer auf ein Minimum reduziert werden. Hier tritt jedoch eine wesentliche Erschwerung und Verzögerung durch die Wasserkühleinrichtung ein. Zum Tausch einer gestörten Baugruppe muß nämlich nach Ablassen des Kühlwassers der Kühlwasseranschluß demontiert werden. Dabei besteht immer die Gefahr einer Beschädigung der Geräte durch ausfließendes Restwasser. Nach Einsetzen einer neuen Baugruppe muß deren Kühlwasseranschluß sorgfältig wiederhergestellt und das Kühlwasser neu eingeleitet werden.

Aufgabe der Erfindung ist es, eine neue Einrichtung zu schaffen, bei der der Austausch der wassergekühlten Bauteilträger wesentlich rascher und einfacher zu bewältigen ist. Diese ist dadurch gekennzeichnet, daß das Trägerelement, auf dem die Bauteile angeordnet sind, als vom Kühlkörper unabhängiger Bauteilträger ausgebildet ist, daß mit jedem der im Verband eines Einschubes einzeln oder in Mehrzahl in das Gerät eingeschobenen Bauteilträger in dessen betriebsmäßiger Endlage je ein wasserdurchflossener, auf federnden Elementen im wesentlichen gerätefest gelagerter Kühlkörper durch die Kraft der federnden Elemente an genau aufeinanderpassenden, an Bauteilträgern und Kühlkörpern ausgebildeten Wärmeübergangsflächen individuell in unmittelbare, druckhaft-flächige thermische Wirkverbindung bringbar ist und daß alle Kühlkörper gemeinsam durch eine auf sie in gleicher Weise einwirkende Vorrichtung entgegen der Wirkungsrichtung der Kräfte der federnden Elemente verschiebbar und damit von den zugehörigen Bauteilträgern distanzierbar sind.

Der Vorteil der erfindungsgemäßen Einrichtung liegt darin, daß durch sie ohne
Einschränkung der Funktionalität eine wesentliche Verkürzung der für den
Austausch von Einschüben bzw. Bauteilträgern erforderlichen Arbeitszeit
und damit der Ausfallszeit des Gerätes erreicht werden kann, da durch das
erfindungsgemäße Prinzip jede Manipulation an Einrichtungen des Kühlwasserkreislaufes entbehrlich ist. Aus diesem Grunde kann auch keine Beschädigung
des Gerätes durch ausfließendes Restwasser erfolgen.

Eine vorteilhafte Ausführungsform der erfindungsgemäßen Einrichtung ist
dadurch gekennzeichnet, daß als federnde Elemente Schraubenfedern vorgesehen sind, die zwischen den Kühlkörpern und parallel zur Einschubrichtung
für die Einschübe im Gehäuse angeordneten Kühlkörpertragplatten eingesetzt
sind und daß zu der für die gemeinsame Distanzierung der Kühlkörper von
den zugehörigen Bauteilträgern notwendigen gemeinsamen Verschiebung der
Kühlkörper entgegen der wirkenden Kraft der Schraubenfedern für jede Reihe
von Kühlkörpern zwei, parallel zur Richtung dieser Reihe angeordnete Wellen
mit im wesentlichen halbkreisförmigem Querschnitt vorgesehen sind, die auf
der Kühlkörpertragplatte gelagert und gegenläufig zueinander verdrehbar sind,
wobei an entgegengesetzten Seiten der Kühlkörper Stege angeordnet sind, auf
die die Wellen bei ihrer Verdrehung zufolge des Durchmessersprunges ihres
Querschnittes einwirken.

Der Vorteil dieser Maßnahmen liegt darin, daß auch bei einer Mehrzahl von,
auf einem Einschub angeordneten Bauteilträgern für deren zugeordnete Kühlkörper statische Unbestimmtheit vermieden wird obwohl deren druckhafte
Wirkverbindung mit den Bauteilträgern für alle zugleich hergestellt wird,
daß in Form der Wellen ideale Antriebselemente geschaffen sind da sie den
gegebenen Platzverhältnissen hervorragend entsprechen, daß das gemeinsame
Antriebsorgan für die Wellen an einem ihrer Enden konzentriert werden kann
und daß die Reaktionskraft der federnden Elemente zur Gänze über die Lagerungen der Wellen in die Kühlkörpertragplatte übertragen werden und so
das Antriebsorgan in beiden Endlagen frei von Reaktionskräften ist und daß letztlich durch die zueinander gegenläufige Verdrehung der Wellen am Kühlkörper keine störende resultierende Kraft senkrecht zur gewünschten Bewegungsrichtug auftritt.

Eine vorteilhafte Ausgestaltung der Antriebselemente ist dadurch gekennzeichnet, daß die Wellen an gleichen Enden Kurbelarme aufweisen, daß diese Kurbelarme gelenkig mit Schubstangen und über diese Schubstangen mit einem Antriebsorgan verbunden sind und daß bei Geräten, die mehrere Etagen von Einschüben aufweisen, die Antriebselemente für die, weiteren Etagen zugehörigen Kühlkörper in gleicher Weise mit den Schubstangen verbindbar sind.

Hier ist vorteilhaft, daß diese Antriebselemente für die Wellen ganz flach praktisch in einer Ebene angeordnet werden können, die sehr nahe an eine Seitenwand des Gehäuses gelegt werden kann, wobei diese Antriebselemente auch während ihrer Funktion nicht aus dieser Ebene hervortreten. Es ist somit eine Antriebsanordnung geschaffen, die vom meist knappen Geräteinnenraum praktisch nichts beansprucht. Dies gilt auch für die überaus einfache Erweiterung zur Einbeziehung weiterer Einschubetagen.

Ein Ausführungsbeispiel einer erfindungsgemäßen Wasserkühleinrichtung soll nachfolgend anhand der Zeichnungen näher beschrieben werden.

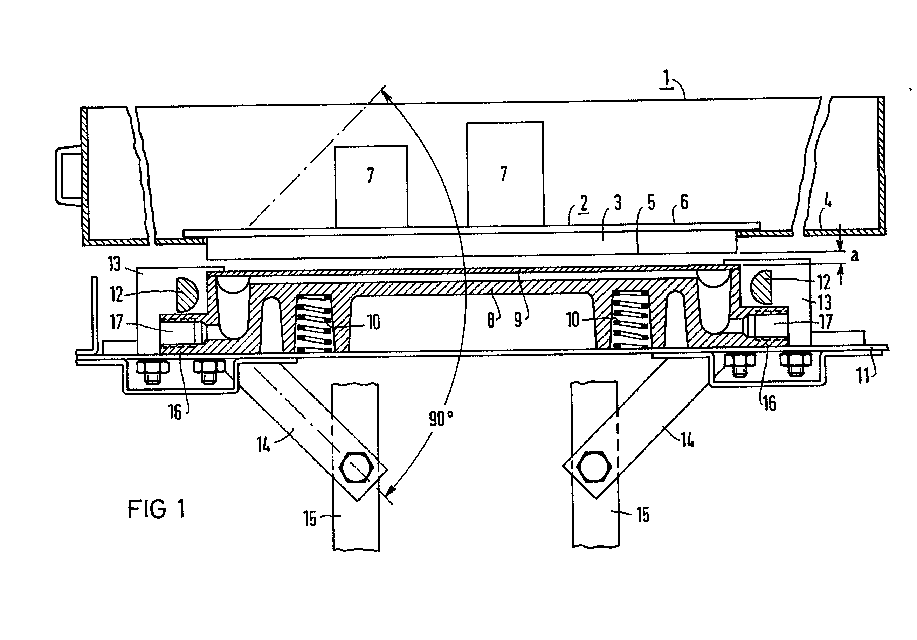

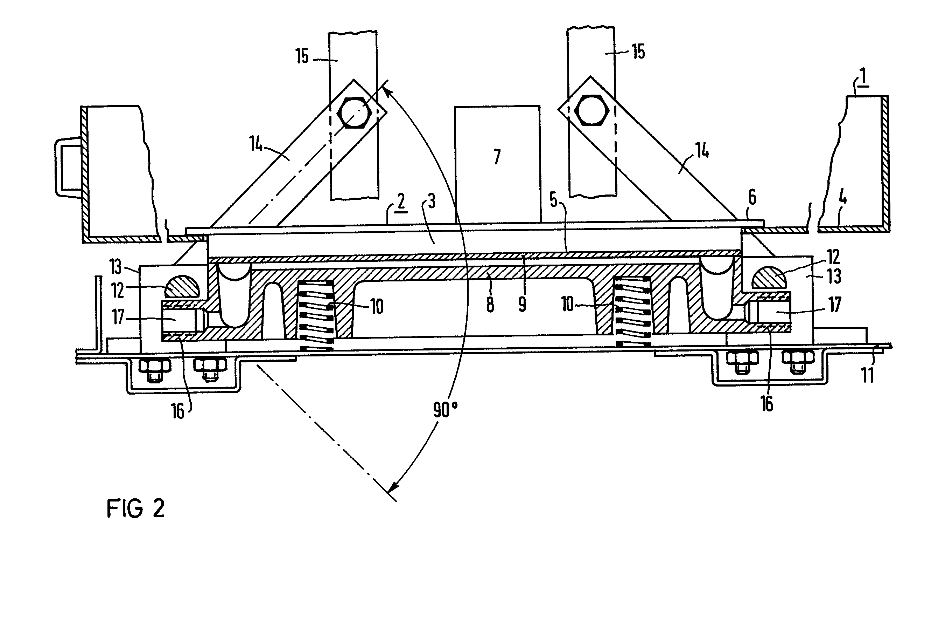

Die Fig. 1 und 2 zeigen im Längsschnitt eine Wasserkühleinrichtung für einen Bauteilträger bei bestehender und bei aufgehobener thermischer Wirkverbindung.

Die Einschübe 1 sind im wesentlichen in Form von Schubladen aufgebaut und in mehreren Etagen in horizontaler Richtung in den Geräteschrank einführbar. Als Bauteilträger 2 sind Kupferplatten 3 horizontal in Ausnehmungen des Bodens 4 des Einschubes 1 in einer, senkrecht zur Einschubrichtung verlaufenden Reihe derart angeordnet, daß ihre unteren Flächen 5 geringfügig aus der unteren Fläche des Bodens 4 nach unten herausragen. Auf den oberen Flächen 6 der Bauteilträger 2 sind, wie hier angedeutet, mit gutem thermischen Kontakt die elektrischen Bauteile 7, insbesondere die Bauteile

0235657

- 5 -

mit hoher Verlustwärmeerzeugung befestigt. Die unteren Flächen 5 sollen
vorteilhaft mit sehr geringer Oberflächenrauhigkeit hergestellt sein. Sie
sind nämlich als Wärmeübergangsflächen 5 zu wasserdurchflossenen Kühlkörpern 8 vorgesehen, an denen genau auf diese Wärmeübergangsflächen 5 der
Bauteilträger 2 passende Wärmeübergangsflächen 9 ausgebildet sind. Diese
Kühlkörper 8 sind mittels Schraubenfedern 10 auf, horizontal im Geräteschrank
befestigten Kühlkörpertragplatten 11 mit geringer vertikaler Verschieblichkeit a, jedoch im wesentlichen gerätefest angeordnet und derart positioniert,
daß der Wärmeübergangsfläche 5 jedes in die betriebsmäßige Endlage eingeschobenen Bauteilträgers 2 eine Wärmeübergangsfläche 9 eines zugehörigen
Kühlkörpers 8 genau gegenübersteht.

Im Betriebszustand des Gerätes sind die Kühlkörper 8 durch die Schraubenfedern 10 an die eingeschobenen Bauteilträger 2 gepreßt, sodaß durch die
genau aufeinander passenden Wärmeübergangsflächen 5, 9 die unmittelbare
thermische Wirkverbindung zwischen Bauteilträger 2 und Kühlkörper 8 hergestellt ist. Zur Lösung des druckhaften Flächenkontaktes zwecks unbehinderter
Entnahme der Einschübe 1 aus dem Gerät werden alle Kühlkörper 8 gemeinsam
und gleichzeitig gegen die Kraft der Schraubenfedern 10 zurückgeschoben und
so von den zugehörigen Bauteilträgern 2 distanziert. Diese können daher
z.B. in einer parallel zu ihrer Wärmeübergangsfläche 5 verlaufenden Richtung, die die vorgesehene horizontale Einschubrichtung ist, aus dem Gerät
gezogen werden. Zu dieser gemeinsamen Verriegelung der Kühlkörper 8 sind
für jede Reihe von Kühlkörpern 8 zwei, parallel zur Richtung dieser Reihe
angeordnete Wellen 12 mit, im wesentlichen halbkreisförmigem Querschnitt
vorgesehen, die auf der Kühlkörpertragplatte 11 mittels Lagerblöcken 13
zwei- oder mehrfach gelagert sind. Beide Wellen 12 weisen an gleichen Enden
kurze Kurbelarme 14 auf, die mit Schubstangen 15 gelenkig verbunden sind.
An diesen Schubstangen 15 können die analog ausgeführten Vorrichtungen anderer Einschubetagen angeschlossen sein. Durch Betätigung der Schubstangen 15 können beide Wellen 12 jeder Einschubetage gegensinnig zueinander
um etwa 90° verdreht werden. Dabei wirkt der Durchmessersprung ihrer Querschnittsfläche wie ein Exzenter oder eine Nocke auf Stege 16, die an gegenüberliegenden Seiten jedes Kühlkörpers 8 angeordnet sind im Sinne einer

092 01 05

gewünschten Verschiebung des Kühlkörpers 8. In diesen Stegen 16 können sich vorteilhaft die Anschlußgewinde 17 für die hier nicht gezeigten, der Kühlwasserzu- und -abfuhr dienenden flexiblen Druckschläuche befinden.

Patentansprüche:

1. Wasserkühleinrichtung für einschiebbare Bauteilgruppen in Geräten der Leistungselektronik nach dem Prinzip, bei dem im wesentlichen die Verlustwärme aus den Bauteilen durch eine, zur Trennung der Bauteile von dem den Kühlkörper durchströmenden Kühlwasser notwendigen, als Trägerelement ausgebildete Schicht gut wärmeleitenden Metalls unmittelbar in das Kühlwasser abfließt, d a d u r c h   g e k e n n z e i c h n e t , daß das Trägerelement, auf dem die Bauteile (7) angeordnet sind, als vom Kühlkörper unabhängiger Bauteilträger (2) ausgebildet ist, daß mit jedem der im Verband eines Einschubes (1) einzeln oder in Mehrzahl in das Gerät eingeschobenen Bauteilträger (2) in dessen betriebsmäßiger Endlage je ein wasserdurchflossener, auf federnden Elementen (10) im wesentlichen gerätefest gelagerter Kühlkörper (8) durch die Kraft der federnden Elemente (10) an genau aufeinanderpassenden, an Bauteilträgern (2) und Kühlkörpern (8) ausgebildeten Wärmeübergangsflächen (5,9) individuell in unmittelbare, druckhaft-flächige thermische Wirkverbindung bringbar ist und daß alle Kühlkörper (8) gemeinsam durch eine auf sie in gleicher Weise einwirkende Vorrichtung (12-15) entgegen der Wirkungsrichtung der Kräfte der federnden Elemente (10) verschiebbar und damit von den zugehörigen Bauteilträgern (2) distanzierbar sind.

2. Wasserkühleinrichtung nach Anspruch 1, d a d u r c h   g e k e n n z e i c h n e t , daß als federnde Elemente Schraubenfedern (10) vorgesehen sind, die zwischen den Kühlkörpern (8) und parallel zur Einschubrichtung für die Einschübe (1) im Gehäuse angeordneten Kühlkörpertragplatten (11) eingesetzt sind und daß zu der für die gemeinsame Distanzierung der Kühlkörper (8) von den zugehörigen Bauteilträgern (2) notwendigen gemeinsamen Verschiebung der Kühlkörper (8) entgegen der wirkenden Kraft der Schraubenfedern (10) für jede Reihe von Kühlkörpern (8) zwei, parallel zur Richtung dieser Reihe angeordnete Wellen (12) mit im wesentlichen halbkreisförmigem Querschnitt vorgesehen sind, die auf der Kühlkörpertragplatte (11) gelagert und gegenläufig zueinander verdrehbar sind, wobei an entgegengesetzten Seiten der Kühlkörper (8) Stege (16) angeordnet sind, auf die die Wellen (12) bei ihrer Verdrehung zufolge des Durchmessersprunges ihres Querschnittes einwirken.

092 01 07

- 8 -

3. Wasserkühleinrichtung nach Anspruch 1 und 2, d a d u r c h  g e k e n n -
z e i c h n e t ,  daß die Wellen (12) an gleichen Enden Kurbelarme (14) aufweisen, daß diese Kurbelarme (14) gelenkig mit Schubstangen (15) und über
diese Schubstangen (15) mit einem Antriebsorgan verbunden sind und daß bei
Geräten, die mehrere Etagen von Einschüben (1) aufweisen, die Antriebselemente für die, weiteren Etagen zugehörigen Kühlkörper (8) in gleicher Weise
mit den Schubstangen (15) verbindbar sind.

FIG 1

FIG 2

Europäisches
Patentamt

**EUROPÄISCHER RECHERCHENBERICHT**

Nummer der Anmeldung

EP 87 10 2156

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US-A-4 196 775 (GROH)<br>* Spalte 1, Zeilen 11-15; Spalte 2, Zeilen 24-56 * | 1 | H 05 K 7/20 |
| A | EP-A-0 145 212 (BRITISH AEROSPACE)<br>* Seite 5, Zeile 6 - Seite 6, Zeile 16 * | 1 | |

RECHERCHIERTE SACHGEBIETE (Int. Cl.4)

H 05 K

Der vorliegende Recherchenbericht wurde für alle Patentansprüche erstellt.

| Recherchenort | Abschlußdatum der Recherche | Prüfer |
|---|---|---|
| DEN HAAG | 16-06-1987 | TOUSSAINT F.M.A. |